# EUROPÄISCHE PATENTSCHRIFT

(11) **EP 3 093 681 B1**
(45) Veröffentlichungstag und Bekanntmachung des Hinweises auf die Patenterteilung: **05.05.2021**
(21) Anmeldenummer: 16001071.6
(22) Anmeldetag: 12.05.2016
(51) Int. Cl.: G01R 33/385

(54) **EINE MODULAR AUFGEBAUTE ANORDNUNG VON GRADIENTEN- ODER SHIMSPULEN**
A MODULAR DESIGN FOR A GRADIENT- OR SHIM COIL ARRAY
CONCEPTION MODULAIRE POUR PLUSIEURS BOBINES À GRADIENT OU DE SHIM

(30) Priorität: 12.05.2015 DE 102015005944
(43) Veröffentlichungstag der Anmeldung: 16.11.2016
(73) Patentinhaber: Albert-Ludwigs-Universität Freiburg, 79098 Freiburg (DE)
(72) Erfinder: LITTIN, Sebastian, 79115 Freiburg (DE); JIA, Feng, 79115 Freiburg (DE); ZAITSEV, Maxim, 79117 Freiburg (DE)
(74) Vertreter: Maucher Jenkins Patent- und Rechtsanwälte

(56) Entgegenhaltungen:
- WO-A1-2011/054923
- WO-A2-2007/062227
- DE-A1- 19 856 802
- US-A1- 2012 068 707
- US-B1- 6 311 389
- CHRISTOPH JUCHEM ET AL: "Dynamic multi-coil shimming of the human brain at 7T", JOURNAL OF MAGNETIC RESONANCE, Bd. 212, Nr. 2, 23. Juli 2011 (2011-07-23) , Seiten 280-288, XP028299693, ISSN: 1090-7807, DOI: 10.1016/J.JMR.2011.07.005 [gefunden am 2011-07-23]
- S.S. HIDALGO-TOBON: "Theory of gradient coil design methods for magnetic resonance imaging", CONCEPTS IN MAGNETIC RESONANCE PART A, Bd. 36A, Nr. 4, 21. Juli 2010 (2010-07-21) , Seiten 223-242, XP055183938, ISSN: 1546-6086, DOI: 10.1002/cmr.a.20163
- TURNER ET AL: "Gradient coil design: A review of methods", MAGNETIC RESONANCE IMAGING, ELSEVIER SCIENCE, TARRYTOWN, NY, US, Bd. 11, Nr. 7, 1. Januar 1993 (1993-01-01) , Seiten 903-920, XP026307603, ISSN: 0730-725X, DOI: 10.1016/0730-725X(93)90209-V [gefunden am 1993-01-01]
- SEBASTIAN LITTIN ET AL.: "Shielded Matrix Gradient Coil", PROCEEDINGS OF THE INTERNATIONAL SOCIETY FOR MAGNETIC RESONANCE IN MEDICINE, ISMRM, 23RD ANNUAL MEETING AND EXHIBITION, TORONTO, ONTARIO, CANADA, 30 MAY - 5 JUNE 2015, Nr. 1022, 15. Mai 2015 (2015-05-15), XP040666702,
- SEBASTIAN LITTIN ET AL.: "Sinusoidal PatLoc imaging using matrix gradient coils", PROCEEDINGS OF THE INTERNATIONAL SOCIETY FOR MAGNETIC RESONANCE IN MEDICINE, ISMRM, 21ST ANNUAL MEETING AND EXHIBITION, SALT LAKE CITY, UTAH, USA, 20-26 APRIL 2013, 7. April 2013 (2013-04-07), Seite 2709, XP040630305,
- JIA FENG ET AL: "Performance evaluation of matrix gradient coils", MAGNETIC RESONANCE MATERIALS IN PHYSICS, BIOLOGY AND MEDICINE, SPRINGER, DE, GB, Bd. 29, Nr. 1, 14. Dezember 2015 (2015-12-14), Seiten 59-73, XP035895969, ISSN: 0968-5243, DOI: 10.1007/S10334-015-0519-Y [gefunden am 2015-12-14]

## Beschreibung

Die Erfindung betrifft eine Anordnung von Gradienten- und/oder Shimspulen zur Modifizierung eines in einem Magnetresonanz-Tomographen generierten Hauptmagnetfeldes. Die Anordnung weist eine Trägerstruktur auf.

Handelsübliche Magnetresonanz-Tomographen (MR-Tomographen) und somit auch: MR-Spektrometer mit der Bildgebungsfunktion sind häufig mit einer derartigen Anordnung ausgestattet. Sie umfasst üblicherweise drei auf eine gemeinsame zylinderförmige Trägerstruktur gewickelte Gradientenspulen und/oder eine bestimmte Anzahl von Shimspulen.

Die Erfindung betrifft ferner ein Verfahren zur Herstellung einer Anordnung der eingangs beschriebenen Art. Derartige Herstellungsverfahren sind bekannt.

Die MR-Tomographie stellt ein bildgebendes Verfahren dar, welchem große Bedeutung beispielsweise in der medizinischen Diagnostik zur Darstellung von Struktur und Funktion von Gewebe und Organen zukommt.

Um Kernspins eines Untersuchungsobjekts auszurichten, weist ein MR-Tomograph im Regelfall einen Hauptmagneten auf, mit dem ein möglichst statisches und nahezu homogenes Hauptmagnetfeld, häufig auch als B0-Feld bezeichnet, in einer z-Richtung generierbar ist. Hierzu wird oftmals ein supraleitender Hauptmagnet eingesetzt, mit dem eine Feldstärke beispielsweise zwischen 0,5 T und 3 T generierbar ist.

Ein Gradientensystem dient vor allem der Ortskodierung, mittels derer Ortsinformationen über die von einer RF-Empfangsspule aufgenommenen Messsignale erhalten werden können. Hierzu werden gezielt elektrische Ströme von speziellen Stromquellen, sogenannten Gradientenverstärkern, erzeugt und durch primäre Spulen einer eingangs beschriebenen Anordnung geleitet. Stärke und Richtung der Ströme sind dabei mittels einer Steuereinheit einstellbar. Im Stand der Technik bilden in aller Regel x-, y- und z-Spulen die primären Spulen. Mit einem derartigen System von x-, y- und z-Spulen ist ein das Hauptmagnetfeld modifizierendes Primärmagnetfeld erzeugbar, dessen z-Komponente im Untersuchungsbereich linear variiert. Hierbei kann durch geeignete Einstellung der Spulenströme ein Feldgradient beliebiger Orientierung generiert werden. Dies ist Folge des Superpositionsprinzips und der Tatsache, dass mit der x-Spule (y-, z-Spule) ein Primärmagnetfeld mit einem Feldgradienten in x-Richtung (y-, z-Richtung) erzeugbar ist.

Ein Gradientensystem kann auch eine Abschirmeinheit ("shield") mit drei sekundären x-, y- und z- Spulen aufweisen, mit denen ein Sekundärmagnetfeld erzeugbar ist, welches das von den primären x-, y- und z-Spulen generierte Primärmagnetfeld nach außen abschirmt, insbesondere um nachteilhafte Interaktionen mit anderen Komponenten des MR-Tomographen, insbesondere mit dem Kryostat und Komponenten des Hauptmagneten, zu reduzieren oder zu verhindern. Es ist hierbei erforderlich, die Abschirmspulen mit den Primärspulen elektrisch zu koppeln. Dies erfolgt üblicherweise nachträglich mittels Verlötens, wodurch die primären Spulen mit den entsprechenden sekundären Spulen elektrisch verbunden werden. Eine derartige Herstellungsweise ist jedoch umständlich.

Ein MR-Tomograph ist häufig mit einem Shimsystem ausgestattet. Das Shimsystem hat den Zweck, Inhomogenitäten des Hauptmagnetfeldes auszugleichen, sogenanntes "Shimmen". Mit den x-, y- und z-Spulen eines Gradientensystems können lediglich lineare Inhomogenitäten korrigiert werden. Beim sogenannten "aktiven Shimmen" werden zur Korrektur von Inhomogenitäten höherer Ordnung nach dem Stand der Technik Shimspulen verwendet, welche dazu eingerichtet sind, Magnetfelder höherer Ordnung zu generieren, wobei jede Shimspule ein Magnetfeld einer bestimmten Ordnung generiert.

Da die Anforderungen von Shimsystemen und Gradientensystemen unterschiedlich sind, kann sich auch die Konstruktionsweise von Gradienten- und Shimspulen unterscheiden. So ergeben sich beispielsweise unterschiedliche Anforderungen an Schaltgeschwindigkeit und genierbare Feldstärke, so dass die Spulen deutlich unterschiedliche Induktivitäts- und Widerstandswerte aufweisen können.

Bei den üblichen MR-Tomographen mit zylinderförmigem Untersuchungsbereich sind auch die Spulen von Gradienten- und Shimsystemen jeweils zylinderförmig ausgebildet und erstrecken sich über die gesamte Länge des Untersuchungsbereichs. Die Spulen bilden hierbei zylindrische Schichten mit unterschiedlichen Radien und sind auf einem gemeinsamen Träger aufgebracht oder bilden eine gemeinsame Trägerstruktur, welche üblicherweise durch Eingießen beispielsweise in Epoxidharz stabilisiert wird.

Als Reaktion darauf, dass derartige Gradienten- und Shimsysteme hinsichtlich der erzeugbaren Magnetfelder nur eine begrenzte Flexibilität aufweisen, gibt es seit einigen Jahren Bemühungen in eine neue Richtung. Sogenannte Matrix-Gradientensysteme weisen eine Vielzahl von kleineren Einzelspulen auf, welche bei geschlossenen Systemen oftmals auf einer zylinderförmigen Oberfläche und bei offenen Systemen oftmals auf zwei ebene Oberflächen verteilt angeordnet sind. Hierbei ist die Vielzahl von Einzelspulen bei den geschlossenen Systemen auf einem zylinderförmigen Trägerelement und bei den offenen Systemen auf höchstens zwei ebenen, voneinander beabstandeten und nicht benachbarten Trägerelementen angeordnet.

Aufgrund der Tatsache, dass mit Matrix-Gradientensystemen hinsichtlich der Form der erzeugbaren Magnetfelder eine hohe Flexibilität erzielbar ist, können derartige Systeme auch als Matrix-Shimsysteme mit geeigneten Widerstands- und Induktivitätswerten ausgelegt sein oder aber derartige Systeme können als kombinierte Gradienten- und Shimsysteme ausgelegt sein.

Aufgrund der Tatsache, dass es sich bei der Matrix-Technologie um eine neue technologische Entwicklung handelt und aufgrund der Komplexität von Matrix-Gradientensystemen sind die wenigen aktuell bekannten Systeme noch im hohen Maße verbesserungsfähig und verbesserungsbedürftig.

Aus DE 102 19 769 B3 sind ein Magnetresonanzgerät und eine mit Shimelementen bestückbare Trägervorrichtung bekannt, wobei ein Gradientenspulensystem im Wesentlichen die Form eines Hohlzylinders aufweist, sich wenigstens ein Aufnahmeraum in Richtung einer Hauptachse des Hohlzylinders erstreckt und wenigstens eine Längsausdehnung in etwa der des Gradientenspulensystems aufweist, wobei wenigstens eine Trägervorrichtung, die in den Aufnahmeraum einbringbar und mit Shimelementen bestückbar ist und wenigstens ein Hohlkörper zum Leiten eines die Shimelemente kühlenden Kühlmediums, der im Aufnahmeraum anordenbar ist, und der sich mit wenigstens einer Längsausdehnung in etwa der des Gradientenspulensystems entlang der Richtung der Hauptachse erstreckt, ausgebildet ist.

Aus DE 198 56 802 A1 ist eine Gradientenspule für Magnetresonanzanlagen mit einer auf einem zentralen Träger gefertigten Primärspule und einer sie umgebenden, zur aktiven Magnetabschirmung dienenden Sekundärspule, die beide in eine Vergussmaße eingebettet sind, bekannt, wobei ein, vorzugsweise den Träger der Sekundärspule bildender, zwischen Primär- und Sekundärspule angeordneter, in die Vergussmaße eingebetteter Segmentkäfig aus vorzugsweise axial durchgehenden Kunststoffprofilen ausgebildet ist.

Aus DE 197 22 211 A1 ist ein Verfahren zum Herstellen einer aktiv geschirmten Gradientenspulenanordnung für ein Magnetresonanzgerät mit einem Primärgradientenspulensatz zum Erzeugen von Gradientenfeldern innerhalb eines Untersuchungsraumes und einem Sekundärgradientenspulensatz zur Schirmung von Streufeldern bekannt, wobei die folgenden Schritte ausgeführt werden: Aufbau aller zum Primärgradientenspulensatz und Sekundärgradientenspulensatz gehörenden Gradientenspulen einzeln oder in Baugruppen mit ein oder zwei Gradientenspulen auf einem ersten Teil einer Vergussform, Vervollständigen der Vergussform zum Vergießen, Vergießen der Gradientenspulen mit einem Vergussmaterial und Entnehmen der Gradientenspulenanordnung aus der Vergussform nach Aushärten des Vergussmaterials.

Aus der WO 2007/062227 A2 sind Resonatoren für Radiofrequenzspulen bekannt, welche aus mehreren Segmenten aufgebaut sind.

In der US 2012/0068707 A1 wird beschrieben, wie eine Gradientenspule aufgebaut und gewickelt werden kann.

In der US 6 311 389 B1 wird eine Technologie zur Herstellung einer zweidimensionalen Leiteranordnung aus einem Plattenmaterial beschrieben.

Der Erfindung liegt die Aufgabe zugrunde, die Gebrauchseigenschaften einer Anordnung der eingangs beschriebenen Art zu verbessern.

Zur Lösung dieser Aufgabe schlägt die Erfindung die Merkmale von Anspruch 1 vor. Insbesondere wird somit erfindungsgemäß bei einer Anordnung der eingangs beschriebenen Art zur Lösung der genannten Aufgabe vorgeschlagen, dass die Trägerstruktur mindestens vier Trägerelemente aufweist, dass an den Trägerelementen jeweils eine Leiteranordnung angeordnet ist und dass diese Leiteranordnungen jeweils eine Primärleiteranordnung zur Generierung eines das Hauptmagnetfeld modifizierenden Primärmagnetfeldes und eine Sekundärleiteranordnung zur Abschirmung des Primärmagnetfeldes umfassen.

Nach dem oben genannten Erfindungsvorschlag ist vorgesehen, dass die Trägerstruktur mindestens vier Trägerelemente aufweist und dass an den Trägerelementen jeweils eine Leiteranordnung angeordnet ist. Die Anordnung weist somit mindestens vier Konstruktionselemente auf, welche jeweils ein Trägerelement und eine Leiteranordnung umfassen. Bei den Leiteranordnungen kann es sich beispielsweise um Spulen handeln.

Die Trägerstruktur weist mindestens vier, vorzugsweise mindestens acht oder eine Vielzahl von Trägerelementen auf, vorzugsweise eine Zahl zwischen 6 und 14 Trägerelementen entlang einer ersten sowie entlang einer zweiten Richtung, beispielsweise 7 mal 12 Trägerelemente. Die Trägerstruktur kann insbesondere aus den Trägerelementen zusammengesetzt und/oder zusammensetzbar und/oder gebildet und/oder bildbar sein. Eine derartige modulare Trägerstruktur kann den entscheidenden Vorteil haben, dass hierdurch Gradienten- und/oder Shimsysteme mit im Vergleich zu Systemen nach dem Stand der Technik verbesserten Eigenschaften konstruierbar sind, wobei die Fertigung der Anordnung aufgrund der Modularität kostengünstig und anwendungsspezifisch erfolgen kann.

So sind hierdurch beispielsweise Primärmagnetfelder unterschiedlichster Geometrie erzeugbar. Es kann auch möglich sein, vorteilhafte Eigenschaften wie beispielsweise eine Abschirmung, Kräftefreiheit und Drehmomentfreiheit der gesamten Anordnung zu erzielen, insbesondere auch dadurch, dass jedes einzelne Konstruktionselement oder die an dem jeweiligen Trägerelement angeordneten Leiteranordnungen oder Teilleiteranordnungen derselben diese vorteilhaften Eigenschaften erfüllen.

Nach dem oben genannten Erfindungsvorschlag ist weiter vorgesehen, dass die Leiteranordnungen jeweils eine Primärleiteranordnung zur Generierung eines das Hauptmagnetfeld modifizierenden Primärmagnetfeldes und eine Sekundärleiteranordnung zur Abschirmung des Primärmagnetfeldes umfassen. Hierdurch können Störfaktoren in ihrer Wirkung reduziert oder eliminiert werden, welche andernfalls die Funktionstauglichkeit der Anordnung negativ beeinflussen könnten. Es ist insbesondere erreichbar, dass die Konstruktionselemente selbstschirmend sind. Es kann zweckmäßig sein, wenn die Primärleiteranordnungen jeweils seriell miteinander verschaltete Leiterabschnitte aufweisen, mit denen Primärmagnetfeldbeiträge entlang der z-Richtung des Hauptmagnetfeldes generierbar sind.

Durch eine Anordnung, welche die Merkmale nach dem oben genannten Erfindungsvorschlag aufweist, werden somit die Gebrauchseigenschaften einer Anordnung der eingangs beschriebenen Art verbessert.

Erfindungsgemäß ist ferner vorgesehen, dass die Primärleiteranordnungen unabhängig voneinander bestrombar sind oder paarweise unabhängig voneinander bestrombar sind. Paarweise unabhängige Bestrombarkeit kann beispielsweise dadurch charakterisiert werden, dass zwei beliebig ausgewählte Primärleiteranordnungen unabhängig voneinander bestrombar sind. Es kann insbesondere vorgesehen sein, dass die Primärleiteranordnungen eine Menge von Primärleiteranordnungen definieren und dass für jede Untermenge dieser Menge mit zwei beliebigen Primärleiteranordnungen gilt, dass diese zwei beliebigen Primärleiteranordnungen unabhängig voneinander bestrombar sind.

Bei einer vorteilhaften Ausgestaltung der Anordnung kann vorgesehen sein, dass die Leiteranordnungen jeweils separat voneinander mit einer Stromquelle und/oder einer Stromversorgung verbindbar sind. Mit derartigen Ausgestaltungen sind Matrix-Anordnungen konstruierbar, mit denen auf flexible Weise Primärmagnetfelder unterschiedlichster Geometrie generierbar sind.

Als Stromquelle kann beispielsweise ein Gradientenverstärker in Betracht kommen. Aus Kostengründen kann es vorteilhaft sein, wenn beim eigentlichen Betrieb der Anordnung nicht jede Leiteranordnung an völlig unabhängig voneinander operierenden Stromquellen angeschlossen wird. So kann es vorteilhaft sein, wenn die Stromquellen von jeweils einem Ausgang einer Verschaltvorrichtung gebildet werden. Zum Betrieb der Anordnung kann beispielsweise eine begrenzte Anzahl von unabhängig voneinander operierenden Gradientenverstärkern an Eingänge der Verschaltvorrichtung und die Leiteranordnungen an Ausgänge der Verschaltvorrichtung angeschlossen werden. Die Verschaltvorrichtung kann hierbei derart eingerichtet sein, dass jeder Eingang mit mindestens einem Ausgang verschaltet ist, dass jedoch auch mehr als ein Ausgang mit dem gleichen Eingang verschaltbar ist. Besonders vorteilhaft ist es, wenn die Verschaltvorrichtung steuerbar ist, so dass die Verschaltung von Eingängen und Ausgängen temporär und/oder veränderbar ist. Wird die Anordnung an eine derartige Verschaltvorrichtung angeschlossen, sind die Leiteranordnungen paarweise unabhängig voneinander bestrombar.

Um die Trägerstruktur besonders stabil konstruieren zu können, ist bei der Anordnung erfindungsgemäß ferner vorgesehen, dass die Trägerelemente mit benachbarten Trägerelementen mechanisch verbunden sind.

Mindestens ein oder jedes Trägerelement kann hierbei jeweils mit mindestens einem, mehr als einem oder allen benachbarten Trägerelementen mechanisch verbunden sein. Es kann auch vorgesehen sein, dass die Trägerelemente benachbarte Trägerelemente kontaktieren. Hierbei kann vorgesehen sein, dass die Trägerstruktur aus separaten Trägerelementen herstellbar ist. Die Trägerelemente können lösbar verbunden sein, so dass die Trägerstruktur in die Trägerelemente zerlegbar ist. Die Trägerelemente können formschlüssig, beispielsweise durch in Aufnahmen eingesetzte oder eingeschobene Aufnahme-Gegenstücke und/oder unter Verwendung von Rastelementen, verbunden sein. Auch eine kraftschlüssige Verbindung kommt alternativ oder zusätzlich in Betracht, beispielsweise durch Verwendung von Passstiften, welche in Bohrungen eines benachbarten Trägerelements einschiebbar sind. Um die Stabilität der Trägerstruktur weiter zu erhöhen, können die Trägerelemente jedoch auch stoffschlüssig mit benachbarten Trägerelementen verbunden sein, beispielsweise mittels eines an Berührungsflächen aufgebrachten Klebemittels.

Zur Stabilisierung der Trägerstruktur ist erfindungsgemäß weiter vorgesehen, dass jedes Trägerelement mindestens eine Aufnahme zur Aufnahme eines Aufnahme-Gegenstücks eines benachbarten Trägerelements hat.

Das Aufnahme-Gegenstück kann insbesondere einstückig mit dem Trägerelement verbunden sein und/oder aus demselben Material wie das Trägerelement gefertigt sein und/oder in die Aufnahme einsetzbar oder einschiebbar sein.

Bei der erfindungsgemäßen Anordnung ist ferner vorgesehen, dass die Leiteranordnungen jeweils mindestens einen Leiter umfassen.

Bei dem mindestens einen Leiter kann es sich beispielsweise um mindestens einen Draht und/oder um mindestens eine Litze und/oder um jeweils eine Vielzahl von Drähten handeln.

Bei einer weiteren vorteilhaften Ausgestaltung der Anordnung kann vorgesehen sein, dass die Leiteranordnungen jeweils aus genau einem Leiter bestehen. Bei dem Leiter kann es sich beispielsweise um einen Draht oder um eine Litze handeln.

Dieser Leiter bildet bei einer solchen Ausgestaltung somit sowohl die Sekundärleiteranordnung als auch die Primärleiteranordnung. Alternativ oder zusätzlich kann vorgesehen sein, dass die Leiteranordnungen jeweils von mindestens einer Spule gebildet sind. Die Leiteranordnungen können auch von einer Wicklung gebildet sein. Vorzugsweise wird hierzu genau eine Spule und/oder Wicklung verwendet. Bei einer weiteren Ausgestaltung kann alternativ oder zusätzlich vorgesehen sein, dass die Leiteranordnungen jeweils verzweigungsfrei ausgebildet sind. Derartige Ausgestaltungen können vorteilhaft sein, da sie besonders kostengünstig herstellbar sind und zugleich einfach betrieben werden können. Insbesondere die einzelnen Konstruktionselemente der Anordnung sind auf besonders effiziente Weise herstellbar, beispielsweise indem ein Draht um das jeweilige Trägerelement gewickelt wird.

Bei einer weiteren vorteilhaften Ausgestaltung der Anordnung kann vorgesehen sein, dass die Leiteranordnungen paarweise eine Verschlingungszahl von null aufweisen. Die Verschlingungszahl kann beispielsweise dadurch charakterisiert werden, dass sie paarweise die Anzahl der Windungen der Leiteranordnungen umeinander misst. Alternativ oder zusätzlich kann vorgesehen sein, dass die Leiteranordnungen knotenfrei voneinander separierbar sind, insbesondere derart, dass die Anordnung durch Auseinanderziehen der Trägerelemente zerlegbar ist. Alternativ oder zusätzlich kann weiter vorgesehen sein, dass die Leiteranordnungen lötstellenfrei angeordnet oder anordenbar sind. Es kann zweckmäßig sein, wenn diese Eigenschaften nicht nur für die Leiteranordnungen als solche gelten, sondern darüber hinaus auch für die Leiteranordnungen zusammen mit mit ihnen, möglicherweise einstückig, verbundenen Anschlussleitern. Derartige Ausgestaltungen können den Vorteil haben, dass die Anordnung konstruierbar ist, ohne Drähte miteinander verlöten zu müssen, und/oder dass die Anordnung unmittelbar aus bereits bestromungsfähigen, fertigen Konstruktionselementen zusammensetzbar ist oder auch in ihre Konstruktionselemente zerlegbar ist, so dass der Fertigungsprozess und/oder Reparaturprozesse vereinfacht werden.

Besonders schnell und kostengünstig kann die Fertigung sein, wenn vorgesehen ist, dass die Leiteranordnungen jeweils auf einer äußeren Oberfläche des jeweiligen Trägerelements angeordnet sind. In einem solchen Fall kann die Anordnung auch derart beschaffen sein, dass sie aus ihren Konstruktionselementen zusammensetzbar ist und wieder in ihre Konstruktionselemente zerlegbar ist. Das jeweilige Trägerelement ist dasjenige Trägerelement, an dem die jeweilige Leiteranordnung angeordnet ist. Es kann alternativ oder zusätzlich vorgesehen sein, dass zumindest ein Leiter oder Leiterabschnitt der Leiteranordnung auf der äußeren Oberfläche des jeweiligen Trägerelements angeordnet ist.

Bei einer weiteren vorteilhaften Ausgestaltung der Anordnung kann vorgesehen sein, dass die Trägerstruktur mindestens zwei voneinander beabstandete Oberflächen bildet. Die Oberflächen können hierbei beispielsweise zylinderförmig oder eben ausgebildet sein. Auch die Trägerstruktur selbst kann zylinderförmig oder eben ausgebildet sein. Alternativ oder zusätzlich kann vorgesehen sein, dass die Trägerelemente jeweils voneinander beabstandete Teiloberflächen aufweisen und dass mindestens zwei Oberflächen der Trägerstruktur, beispielsweise die bereits oben genannten mindestens zwei Oberflächen, von den Teiloberflächen gebildet sind. Solche Ausgestaltungen der Erfindung können beispielsweise den Vorteil haben, dass die Primärleiteranordnungen und die Sekundärleiteranordnungen auf diesen Oberflächen anordenbar sind, so dass beispielsweise die das Primärmagnetfeld generierenden Leiterabschnitte auf einer Fläche angeordnet sind. Um eine ausreichende Flexibilität bei der Generierung des Primärmagnetfeldes zu gewährleisten, sind hierbei die mindestens zwei Oberflächen vorzugsweise jeweils von mindestens drei Teiloberflächen gebildet. Vorzugsweise ist mehr als eine Teiloberfläche, beispielsweise 3, 4 oder 7 Teiloberflächen, entlang einer ersten, beispielsweise axialen, Richtung und mehr als eine Teiloberfläche, beispielsweise 12 Teiloberflächen, entlang einer zweiten, beispielsweise umlaufenden, Richtung ausgebildet. Hierbei können die Oberflächen aus der gleichen oder aus einer unterschiedlichen Anzahl von Teiloberflächen gebildet sein.

Bei einer weiteren vorteilhaften Ausgestaltung der Anordnung kann vorgesehen sein, dass die Trägerelemente in der Trägerstruktur ein zweidimensionales Gitter definieren. Alternativ oder zusätzlich kann vorgesehen sein, dass die Trägerelemente auf wenigstens einer Oberfläche der Trägerstruktur, beispielsweise auf einer der bereits oben erwähnten Oberflächen, ein zweidimensionales Gitter definieren. Hierbei kann das Gitter durch Teiloberflächen der Trägerelemente, beispielsweise die bereits oben erwähnten Teiloberflächen, gebildet sein.

Beispielsweise um eine effektive Selbstschirmung der Konstruktionselemente der Anordnung zu erzielen, kann vorgesehen sein, dass die Trägerstruktur eine äußere Oberfläche und eine innere Oberfläche aufweist und dass die Primärleiteranordnungen an der inneren Oberfläche und die Sekundärleiteranordnungen an der äußeren Oberfläche angeordnet sind. Es kann alternativ oder kumulativ vorgesehen sein, dass die Primärleiteranordnungen mindestens eine erste Fläche definieren und/oder dass die Sekundärleiteranordnungen mindestens eine zweite Fläche definieren.

Eine effektive Selbstschirmung kann insbesondere dann erzielt werden, wenn vorgesehen ist, dass die Trägerelemente jeweils eine obere Teiloberfläche, an der die jeweilige Sekundärleiteranordnung angeordnet ist, und eine untere Teiloberfläche, an der die jeweilige Primärleiteranordnung angeordnet ist, aufweisen.

Alternativ oder zusätzlich kann vorgesehen sein, dass mehrere Teiloberflächen, beispielsweise die oberen Teiloberflächen, eine Oberfläche der Trägerstruktur, beispielsweise die bereits erwähnte äußere Oberfläche, bilden und dass die unteren Teiloberflächen eine Oberfläche der Trägerstruktur, beispielsweise die bereits erwähnte innere Oberfläche, bilden. Alternativ oder zusätzlich kann vorgesehen sein, dass die unteren Teiloberflächen eine mittlere Oberfläche der Trägerstruktur bilden. Ausgestaltungen, bei denen die unteren Teiloberflächen sowohl die mittlere als auch die untere Oberfläche bilden, können besonders vorteilhaft sein, da sie eine hohe Dichte von hinreichend großen und paarweise unabhängig voneinander kontrollierbaren oder bestrombaren Primärleiteranordnungen zulassen, so dass das Primärmagnetfeld räumlich präzise generierbar ist.

Bei einer weiteren vorteilhaften Ausgestaltung der Anordnung kann vorgesehen sein, dass wenigstens zwei Oberflächen der Trägerstruktur relativ zueinander entlang einer ersten Richtung versetzt sind. Alternativ oder zusätzlich kann vorgesehen sein, dass die wenigstens zwei Oberflächen entlang einer zweiten Richtung versetzt sind. Besonders vorteilhaft kann es sein, wenn eine erste Versetzung entlang der ersten Richtung eine halbe Länge eines der Trägerelemente beträgt und/oder wenn eine zweite Versetzung entlang der zweiten Richtung eine halbe Breite eines der Trägerelemente, beispielsweise des bereits soeben erwähnten Trägerelements, beträgt. Insbesondere bei Ausgestaltungen, bei denen die Anordnung zylinderförmig ausgebildet ist, kann es zweckmäßig sein, wenn die erste Richtung eine axiale Richtung und/oder wenn die zweite Richtung eine umlaufende Richtung ist. Eine Versetzung entlang der axialen Richtung kann nämlich vorteilhaft sein, da hierdurch die effektive räumliche Auflösung, mit der das Hauptmagnetfeld beeinflussbar ist, erhöhbar ist. Eine Versetzung entlang der umlaufenden Richtung kann insbesondere den Vorteil haben, dass eine elektrische und/oder induktive und/oder elektromagnetische Kopplung zwischen Leiteranordnungen oder zwischen Primärleiteranordnungen unterschiedlicher Oberflächen reduzierbar ist.

Besonders leicht fertigbar und wirksam kann eine Ausgestaltung der Anordnung sein, bei der vorgesehen ist, dass mindestens zwei Trägerelemente identisch ausgebildet sind. Alternativ oder zusätzlich kann vorgesehen sein, dass mindestens zwei Leiteranordnungen identisch ausgebildet sind oder dass sie zumindest eine gleiche räumliche Topologie aufweisen. Vorzugsweise sind alle Leiteranordnungen, bei denen die Primärleiteranordnungen an derselben Oberfläche der Trägerstruktur angeordnet sind, identisch ausgebildet.

Bei einer weiteren vorteilhaften Ausgestaltung der Anordnung kann vorgesehen sein, dass die an den Trägerelementen angeordneten Leiteranordnungen jeweils zwei topologisch gleiche Teilleiteranordnungen umfassen. Alternativ oder zusätzlich weisen die Leiteranordnungen und/oder die Trägerelemente jeweils eine 180°-Rotationssymmetrie auf. Dies kann vorteilhaft sein, da hierdurch die Anordnung oder auch bereits die Konstruktionselemente der Anordnung oder zumindest Teilleiteranordnungen der Konstruktionselemente besonders vorteilhafte Eigenschaften aufweisen können. So kann hierdurch beispielsweise erreicht werden, dass die einzelnen Konstruktionselemente selbstschirmend sind und/oder dass die Primärleiteranordnungen in einem Hauptmagnetfeld keine resultierende Krafteinwirkung erfahren und somit kräfte- und drehmomentfrei sind.

Belastungsmindernd kann sich auswirken, wenn alternativ oder zusätzlich vorgesehen ist, dass die Leiteranordnungen und/oder die Primärleiteranordnungen und/oder die Sekundärleiteranordnungen derart ausgebildet sind, dass sie jeweils bei Bestromung in einem, insbesondere konstanten, Magnetfeld mit einer definierten Richtung, insbesondere in Gebrauchsstellung in dem Hauptmagnetfeld, kräfte- und/oder drehmomentfrei sind. Dies kann beispielsweise durch Ausnutzen von Symmetrien oder Kenntnissen über physikalische Erhaltungssätze oder unter Verwendung eines Computerprogramms zur Berechnung von Leiterlayouts erreicht werden.

Um eine ausreichende Beabstandung zwischen Primärleiteranordnungen und Sekundärleiteranordnungen zu erreichen, kann vorgesehen sein, dass zumindest eine der Leiteranordnungen, vorzugsweise jede Leiteranordnung, Verbindungsleiter oder Verbindungsleiterabschnitte aufweist, welche die jeweilige Primärleiteranordnung mit der jeweiligen Sekundärleiteranordnung verbinden. Alternativ oder zusätzlich kann vorgesehen sein, dass die Verbindungsleiter oder die Verbindungsleiterabschnitte jeweils an einer axial orientierten Teiloberfläche des jeweiligen Trägerelements verlaufen. Die Verbindungsleiter oder die Verbindungsleiterabschnitte verlaufen dabei vorzugsweise in einem mittigen Bereich des Trägerelements. Dies kann vorteilhaft sein, da auf diese Weise Anordnungen mit mehreren Oberflächen von Primärleiteranordnungen konstruierbar sind, ohne dass ein Verlöten von Drähten erforderlich wäre. Außerdem ist auf diese Weise ein Durchdringen von Leitern unterschiedlicher Leiteranordnungen vermeidbar. Ferner kann vorgesehen sein, dass die Verbindungsleiter oder die Verbindungsleiterabschnitte zwischen der Primärleiteranordnung und der Sekundärleiteranordnung von einer Aufnahme eines benachbarten Trägerelements umfasst werden.

Um eine Fixierung der Leiteranordnung auf den Trägerelementen zu erreichen, kann vorgesehen sein, dass die Trägerelemente jeweils mindestens eine Rille aufweisen, in die zumindest ein Abschnitt mindestens eines Leiters der jeweiligen Leiteranordnung, beispielsweise der bereits oben erwähnte mindestens eine Leiter, einlegbar oder eingelegt ist.

Um die Leiteranordnungen mit der jeweiligen Stromquelle zu verbinden, kann bei einer weiteren vorteilhaften Ausgestaltung der Anordnung alternativ oder zusätzlich vorgesehen sein, dass die Trägerelemente Anschlüsse oder Anschlussstellen für Anschlussleiter aufweisen. Bei den Anschlüssen kann es sich beispielsweise um Stromanschlüsse, insbesondere um Buchsen, handeln. Die Anschlussstellen können beispielsweise als Öffnungen in dem jeweiligen Trägerelement ausgebildet sein oder durch Enden einer oder der Rille in dem jeweiligen Trägerelement oder durch Ränder des jeweiligen Trägerelements gebildet sein. Weist die Leiteranordnung mindestens einen Leiter auf, kann der mindestens eine Leiter auch einstückig mit Anschlussleitern verbindbar sein. Die Anschlussleiter sind Leiter oder Leiterabschnitte, die die jeweiligen Leiteranordnungen mit einer Stromquelle verbinden und regelmäßig nur wenig, vorzugsweise gar kein Magnetfeld in z-Richtung generieren. Die Anschlussleiter dienen somit jeweils der Versorgung der an den jeweiligen Trägerelementen angeordneten Leiteranordnungen. Die Anschlussleiter sind daher zweckmäßigerweise unabhängig von den Leiteranordnungen zu betrachten und bilden formal keinen Bestandteil der Leiteranordnungen, auch wenn sie mit ihnen einstückig verbunden sein können, beispielsweise in Form einer aus einem Draht gebildeten Spule. Es kann zweckmäßig sein, wenn jedes Trägerelement genau zwei Anschlüsse oder Anschlussstellen hat, wobei vorzugsweise der mindestens eine Leiter die Anschlüsse oder die Anschlussstellen miteinander verbindet. Es kann alternativ oder zusätzlich vorgesehen sein, dass die Leiteranordnungen jeweils einen oder genau einen Stromeingang sowie einen oder genau einen Stromausgang aufweisen.

Bei einer weiteren Ausgestaltung der Anordnung kann vorgesehen sein, dass die Trägerelemente jeweils Hohlkammern, insbesondere zur Anordnung von Anschlussleitern, bilden.

Um eine ausreichende Kühlung sicherzustellen, kann vorgesehen sein, dass die Trägerelemente jeweils Abschnitte von Kühlkanälen bilden.

Zur Lösung der genannten Aufgabe sind erfindungsgemäß die Merkmale des auf ein Verfahren zur Herstellung einer Anordnung der eingangs beschriebenen Art gerichteten nebengeordneten Anspruchs vorgesehen. Insbesondere wird zur Lösung der genannten Aufgabe somit erfindungsgemäß bei einem Verfahren der eingangs beschriebenen Art vorgeschlagen, dass auf die bereits oben erwähnten mindestens vier Trägerelemente, jeweils die bereits oben erwähnte jeweilige Leiteranordnung aufgebracht wird und dass sodann die Trägerelemente zu der Trägerstruktur zusammengesetzt werden. Besonders vorteilhaft kann es sein, wenn dies erfolgt, indem die Trägerelemente mit benachbarten Trägerelementen verbunden werden, insbesondere mechanisch verbunden werden. Dies kann beispielsweise dadurch erfolgen, dass die Trägerelemente ineinander geschoben und/oder ineinander gesetzt und/oder miteinander verrastet werden und/oder aneinander gelegt und über Befestigungsmittel miteinander verbunden werden. Es kann auch vorgesehen sein, dass mindestens ein Trägerelement oder jedes Trägerelement jeweils mit mindestens einem oder mit allen benachbarten Trägerelementen mechanisch verbunden werden. Derartige Verfahren können vorteilhaft sein, da sie eine modulare Konstruktion eines flexiblen Gradienten- und/oder Shimsystems von hoher Effektivität gestattet.

Bei dem erfindungsgemäßen Verfahren ist vorgesehen, dass eine Anordnung verwendet wird, die erfindungsgemäß, insbesondere wie zuvor beschrieben und/oder nach einem der auf eine Anordnung gerichteten Schutzansprüche, ausgebildet ist. Die Merkmale derartiger Ausgestaltungen einer erfindungsgemäßen Anordnung begünstigen eine kostengünstige modulare Bauweise eines flexiblen und effektiven Gradient- und/oder Shimsystems und können sich somit positiv auf ein erfindungsgemäßes Verfahren auswirken.

Um die Stabilität der Anordnung zu erhöhen und/oder um die Anordnung elektrisch zu isolieren oder vor Umwelteinflüssen zu schützen und/oder um der Trägerstruktur eine gewünschte Form zu geben, kann vorgesehen sein, dass, nachdem die Trägerelemente zu der Trägerstruktur zusammengesetzt sind, die Anordnung mit einer Vergussmasse, vorzugsweise mit Epoxidharz, vergossen wird.

Um den Herstellungsprozess weiter zu vereinfachen, kann bei einer weiteren vorteilhaften Ausgestaltung des Verfahrens vorgesehen sein, dass die Leiteranordnungen jeweils durch ein technisches Verfahren, beispielsweise durch Ätzen, Fräsen, 3D-Drucken oder Gießen, geschaffen und/oder auf das jeweilige Trägerelement aufgebracht werden. Alternativ oder zusätzlich kann vorgesehen sein, dass die Leiteranordnungen jeweils aus genau einem Leiter, beispielsweise dem bereits oben erwähnten Leiter, bestehen, wobei der Leiter auf das jeweilige Trägerelement aufgebracht wird, indem er auf das Trägerelement gewickelt oder aufgewickelt wird.

Zum Betrieb einer bereits hergestellten Anordnung werden die Leiteranordnungen zweckmäßigerweise jeweils über Anschlussleiter an eine Stromquelle, insbesondere an einen Verstärker oder an einen Ausgang einer an mehrere Verstärker angeschlossenen steuerbaren Verschaltvorrichtung, angeschlossen.

Die Erfindung kann auch ein Gradientensystem betreffen, welches eine Anordnung aufweist, die erfindungsgemäß, insbesondere wie zuvor beschrieben und/oder nach einem der auf eine Anordnung gerichteten Schutzansprüche, ausgebildet ist. Die Erfindung kann auch ein Shimsystem oder ein kombiniertes Gradienten- und Shimsystem mit einer derartigen erfindungsgemäßen Anordnung betreffen.

Die Erfindung wird nun anhand einiger weniger Ausführungsbeispiele näher beschrieben, ist jedoch nicht auf diese wenigen Ausführungsbeispiele beschränkt. Weitere Ausführungsbeispiele ergeben sich durch Kombination der Merkmale einzelner oder mehrerer Schutzansprüche untereinander und/oder mit einzelnen oder mehreren Merkmalen der Ausführungsbeispiele.

Es zeigt:
Fig. 1 ein Konstruktionselement der Anordnung mit Sicht von unten,
Fig. 2 das in Fig. 1 gezeigte Konstruktionselement mit Sicht von oben,
Fig. 3 ein anderes Konstruktionselement der Anordnung mit Sicht von unten,
Fig. 4 das in Fig. 3 gezeigte Konstruktionselement mit Sicht von oben,
Fig. 5 eine erfindungsgemäße Anordnung,
Fig. 6 mehrere zusammengesetzte Konstruktionselemente mit Sicht von innen,
Fig. 7 die in Fig. 6 gezeigten Konstruktionselemente mit Sicht von außen.

Bei der nachfolgenden Beschreibung verschiedener Ausführungsbeispiele der Erfindung erhalten in ihrer Funktion übereinstimmende Elemente auch bei abweichender Gestaltung oder Formgebung übereinstimmende Bezugszahlen.

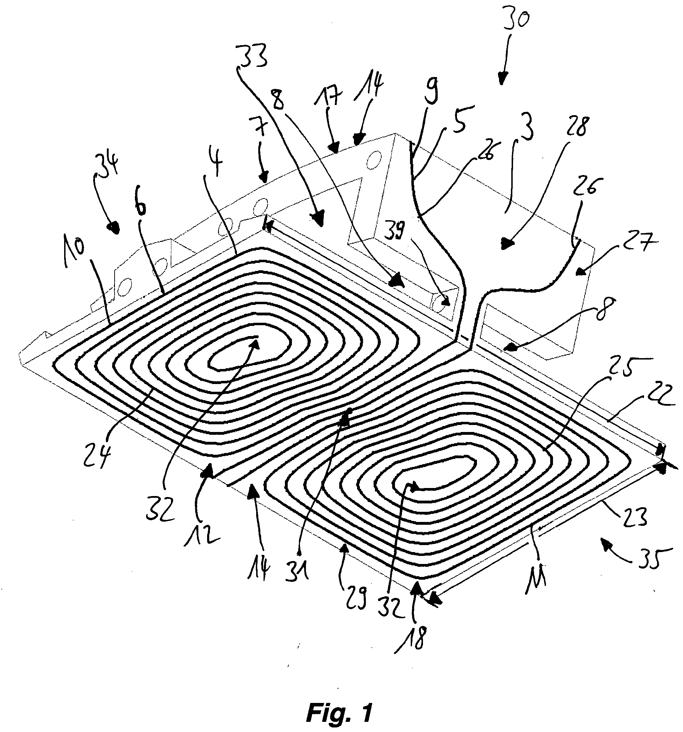

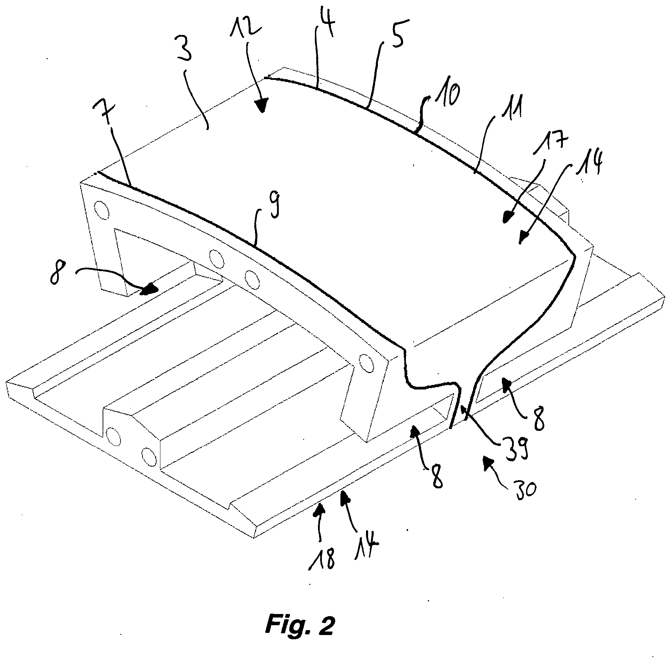

Fig. 1 und Fig. 2 zeigen ein Konstruktionselement 30 aus zwei unterschiedlichen Perspektiven. In Fig. 1 ist die ein Primärmagnetfeld erzeugende Primärleiteranordnung 6 sichtbar. In Fig. 2 ist hingegen die Sekundärleiteranordnung 7 erkennbar, welche der Abschirmung des Primärmagnetfeldes nach oben dient, indem das Primärmagnetfeld nach oben hin signifikant reduziert wird.

Das Konstruktionselement 30 weist ein Trägerelement 3 auf. Das Trägerelement 3 ist aus Kunststoff mit einem 3D-Drucker gefertigt und besteht somit aus einem isolierenden Material. In einem alternativen Ausführungsbeispiel kann das Trägerelement 3 beispielsweise auch aus einem Kunststein gefertigt sein. An dem Trägerelement 3 ist eine als Draht 9 ausgebildete Leiteranordnung 4 angeordnet. Die Leiteranordnung 4 umfasst somit genau einen Leiter 5, der um das Trägerelement 3 gewickelt ist. Der Draht 9 bildet somit eine Spule 10 und eine Wicklung 11. Der Draht 9 ist dabei derart auf das Trägerelement 3 aufgewickelt, dass er auf einer äußeren Oberfläche 12 des Trägerelements 3 verläuft. Hierzu ist in dem Trägerelement 3 eine nicht explizit abgebildete Rille 29 ausgebildet, in die der Draht 9 eingelegt ist.

Das Trägerelement 3 weist zwei voneinander beabstandete Teiloberflächen 14 auf, wobei eine Teiloberfläche 14 durch die obere Teiloberfläche 17 und die andere Teiloberfläche 14 durch die untere Teiloberfläche 18 gebildet ist. Auf der unteren Teiloberfläche 18 des Trägerelements 3 ist ein Abschnitt des Drahts 9 im Wesentlichen schneckenförmig angeordnet und bildet die Primärleiteranordnung 6 der Leiteranordnung 4. Wird der Draht 9 von Strom durchflossen, so generiert die Primärleiteranordnung 6 ein Primärmagnetfeld, welches sich in Gebrauchsstellung mit den von den Primärleiteranordnungen 6 anderer Trägerelemente 3 generierten Primärmagnetfeldern überlagert und nach Einbau in einen MR-Tomographen dazu in der Lage ist, das Hauptmagnetfeld: zu modifizieren. Aufgrund des Superpositionsprinzips bildet die Überlagerung der einzelnen Primärmagnetfelder ebenfalls ein Primärmagnetfeld.

Der Draht 9 ist derart auf das Trägerelement 3 gewickelt, dass die von ihm gebildete Leiteranordnung 4, wie auch das Trägerelement 3 selbst, eine Rotationssymmetrie aufweist. Hierbei handelt es sich um eine 180°-Rotationssymmetrie an einer Achse, welche vertikal auf der unteren Teiloberfläche 18 steht und den Rotationspunkt 31 passiert. Diese Rotationssymmetrie führt dazu, dass die Leiteranordnung 4 nicht lediglich aus zwei topologisch gleichen Teilleiteranordnungen 24, 25, sondern sogar aus zwei identischen Teilleiteranordnungen 24, 25 besteht. Jede der beiden Teilleiteranordnungen 24, 25 besteht aus einem schneckenförmig angeordnete Drahtabschnitt auf der unteren Teiloberfläche 18, zwei auf gegenüberliegenden Teiloberflächen 27 angeordneten Verbindungsleitern 26, einem in Fig. 2 abgebildeten länglich angeordneten Drahtabschnitt auf der oberen Teiloberfläche 17 und einem Leiterabschnitt, der vom Rand des Trägerelements 3 bis zum Rotationspunkt 31 verläuft. Die Verbindungsleiter' 26 verbinden hierbei die Primärleiteranordnung 6 mit der Sekundärleiteranordnung 7 und verlaufen jeweils an einer in Gebrauchsstellung axial orientierten Teiloberfläche 27 des Trägerelements 3 in einem mittigen Bereich 28 desselben. Die 180°-Rotationssymmetrie mit dem zweifachen schneckenförmigen Leiterlayout auf der unteren Teiloberfläche 18 führt ferner dazu, dass die Primärleiteranordnung 6 in einem Hauptmagnetfeld, welches entlang einer Längskante des Trägerelements 3 orientiert ist, keinem resultierenden Drehmoment und keiner translatorisch wirkenden resultierenden Kraft ausgesetzt ist.

Der Draht 9 ist mit Anschlussleitern einstückig verbindbar und somit mit einer Stromquelle verbindbar. Hierzu weist das Trägerelement 3 in der Mitte der beiden schneckenförmige Drahtverläufe jeweils eine nicht gezeigte Öffnung 32 auf, durch die der jeweilige Anschlussleiter geführt werden kann und an einer Seite 34, 35 des Trägerelements 3 aus dem innerhalb des Trägerelements 3 gebildeten Hohlraum 33 hinaus zu einer Stromquelle geführt werden kann.

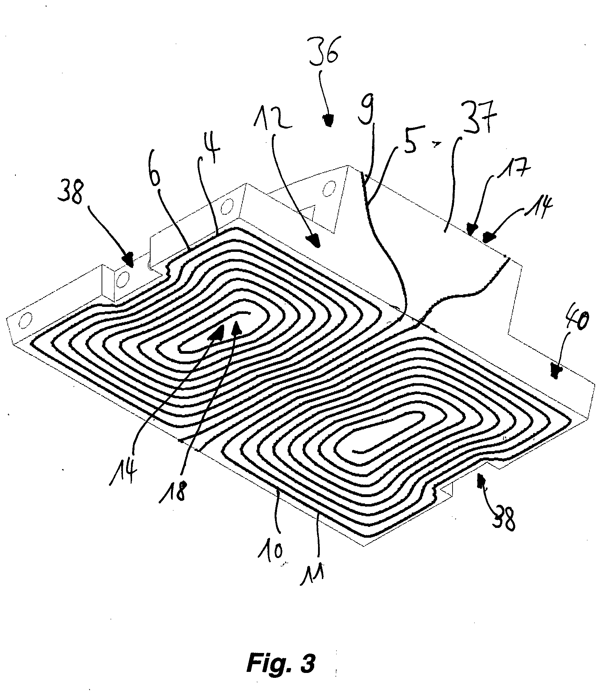

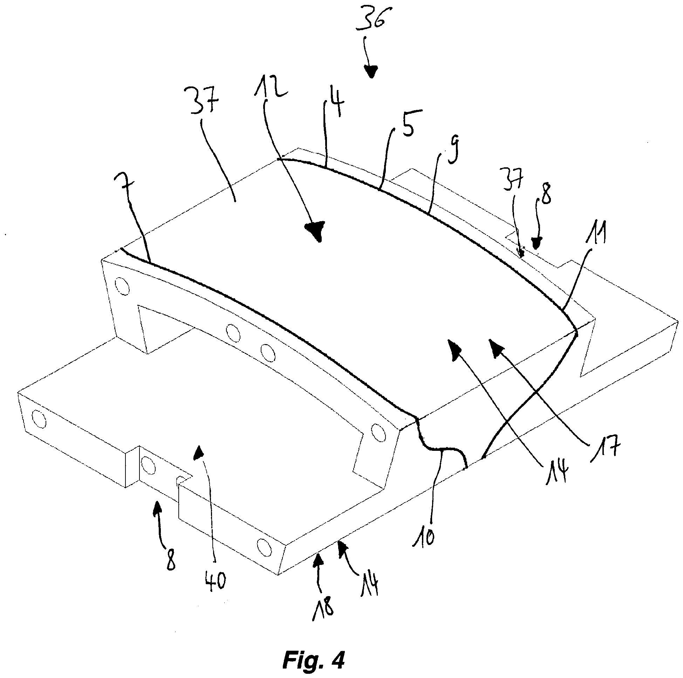

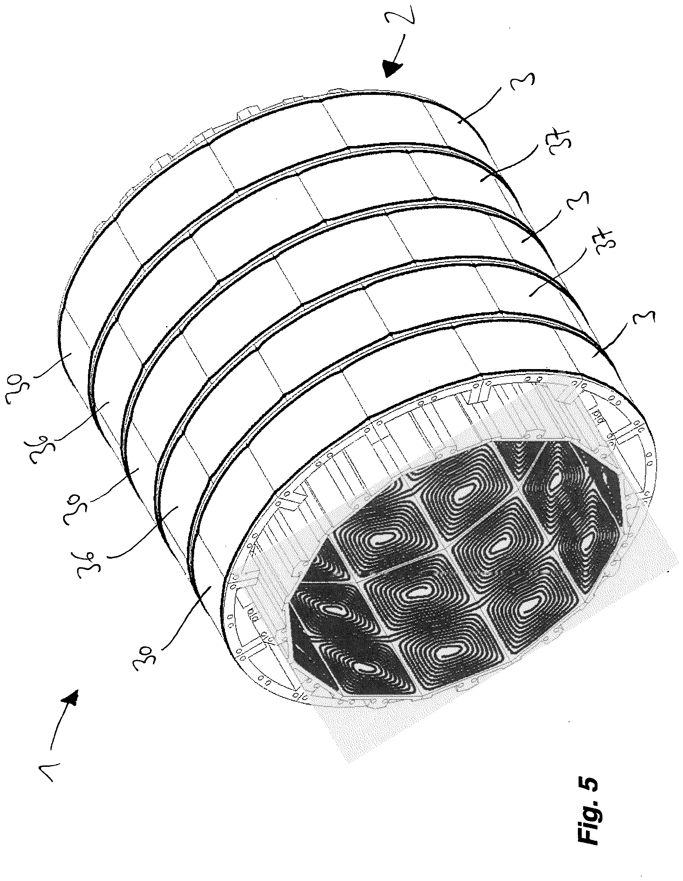

Fig. 3 und Fig. 4 zeigen ein Konstruktionselement 36, welches abweichend von dem in Fig. 1 und Fig. 2 gezeigten Konstruktionselement 30 gestaltet ist. Das in Fig. 3,4 abgebildete Trägerelement 37 ist etwas flacher als das in Fig. 1,2 gezeigte Trägerelement 3. Das Konstruktionselement 36 hat zwei Aufnahmen 38, die derart dimensioniert sind, dass in sie die als Aufnahme-Gegenstücke dienende Stege 39 von zwei aneinandergelegten Trägerelementen 3 der in Fig. 1,2 dargestellten Art aufnehmbar sind. Entsprechend weist die als Aufnahme-Gegenstück dienende untere Platte 40 des Trägerelements 37 eine Dicke auf, welche an die Breite der Aufnahmen 8 des Trägerelements 3 aus Fig. 1,2 angepasst ist. Das Trägerelement 3 ist somit in das Trägerelement 37 einsetzbar und umgekehrt, so dass aus diesen beiden Arten von Trägerelementen 3, 37 eine Trägerstruktur 2 zusammengesetzt werden kann, s. Abb. 5 - 7.

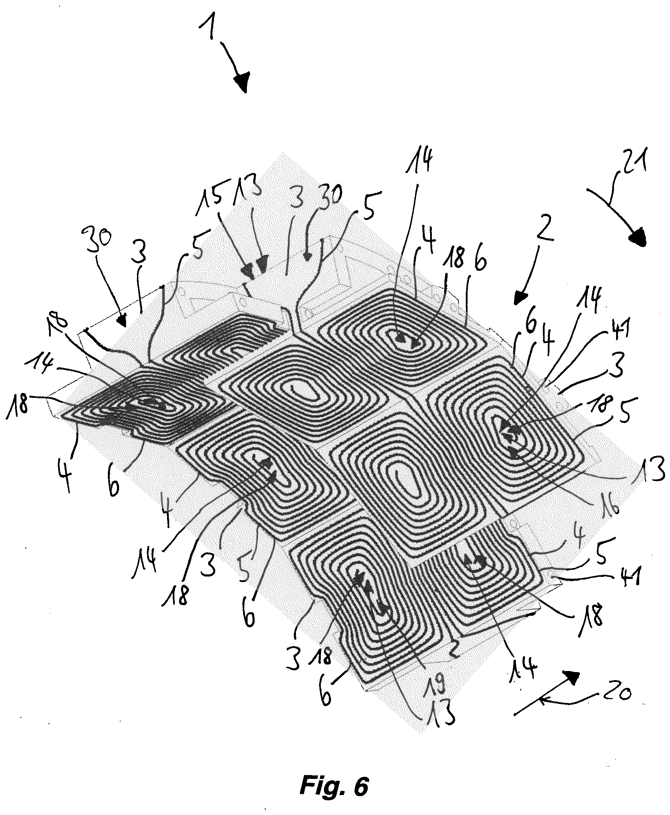

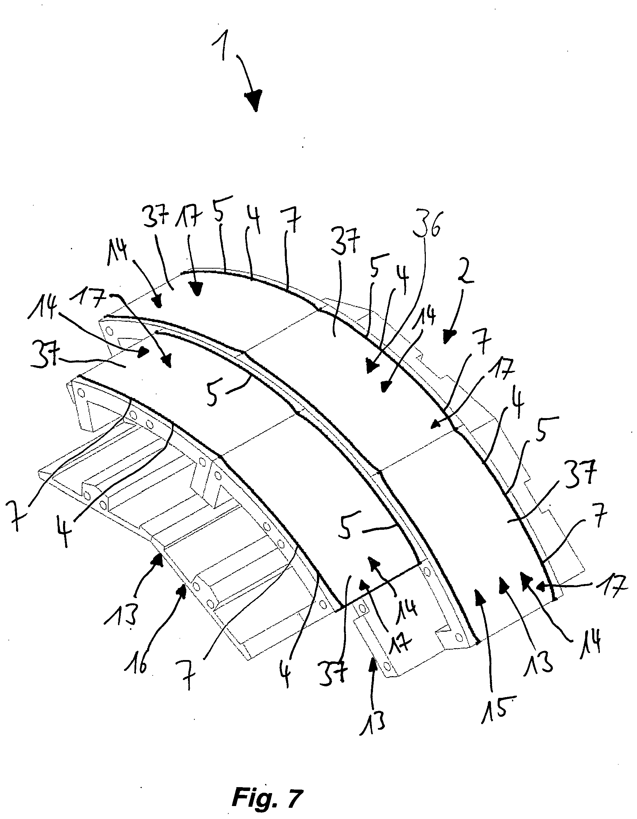

Fig. 5 zeigt ein erfindungsgemäße Anordnung 1, welche aus den beiden Arten von Konstruktionselementen 30, 36 wie in Fig 1 - Fig. 4 dargestellt, zusammengesetzt ist. Die Anordnung 1 besteht insgesamt aus 5 mal 12 Konstruktionselementen 30, 36, konkret aus 3 mal 12 Konstruktionselementen 30 der Art nach Fig. 1,2 und aus 2 mal 12 Konstruktionselementen der Art nach Fig. 3,4. In einem alternativen Ausführungsbeispiel hat die Anordnung 1 insgesamt 7x12 Konstruktionselemente 30, 36. Nähere Details der Anordnung 1 sind aus Fig. 6 und Fig. 7 erkennbar, welche mehrere zusammengesetzte Konstruktionselemente 30, 36 aus zwei unterschiedlichen Perspektiven zeigen.

Wie aus Fig. 5 - 7 ersichtlich, ist die zylinderförmige Trägerstruktur 2 aus mechanisch miteinander verbundenen Trägerelementen 3, 37 zusammengesetzt. Die Anordnung 1 ist hierbei von zwei Gruppen identisch ausgebildeter Konstruktionselemente 30, 36 zusammengesetzt. Innerhalb jeder dieser zwei Gruppen von Konstruktionselementen 30, 36 sind somit die Trägerelemente 3, 37 und den an ihnen angeordneten Leiteranordnungen 4 identisch ausgebildet. Darüber hinaus weist jede Gruppe eine schneckenförmige Doppelstruktur auf, so dass die Primärleiteranordnungen 5 der beiden Arten von Konstruktionselementen 30, 36 die gleiche räumliche Topologie aufweisen.

Die Trägerstruktur 2 bildet drei voneinander beabstandete zylinderförmige Oberflächen 13, an denen Abschnitte von Leitern 5 angeordnet sind. Die Trägerstruktur 2 hat eine äußere Oberfläche 15, an der die Sekundärleiteranordnungen 7 der einzelnen Konstruktionselemente 30, 36 angeordnet sind. Hierbei sind die Trägerelemente 3 derart dimensioniert, dass ihre jeweiligen viereckigen oberen Teiloberflächen 17 aneinandergelegt die äußere Oberfläche 15 bilden. Die Trägerstruktur 2 hat weiter eine innere Oberfläche 16, an der die Primärleiteranordnungen 5 der in Fig. 1,2 gezeigten Art von Konstruktionselementen 30 angeordnet sind. Die innere Oberfläche 16 ist hierbei von den unteren Teiloberflächen 18 dieser Art von Konstruktionselementen 30 gebildet. Ferner hat die Trägerstruktur 2 eine mittlere Oberfläche 19, an der die Primärleiteranordnungen 5 der in Fig. 3,4 gezeigten Art von Konstuktionselementen 36 angeordnet sind und welche von den unteren Teiloberflächen 18 dieser Art von Konstruktionselementen 36 gebildet sind.

Die mittlere Oberfläche 19 und die innere Oberfläche 16 der Trägerstruktur 2 sind zueinander entlang der axialen ersten Richtung 20 um eine halbe Länge 22 eines Trägerelements 3, 37 und entlang der umlaufenden zweiten Richtung 21 um eine halbe Breite 23 eines Trägerelements 3, 37 versetzt angeordnet. Diese Anordnung ist optimal, da sie zu einer geringen Kopplung zwischen den Primärleiteranordungen 5 führt und da sie zu einer erhöhten räumlichen Formbarkeit eines zu generierenden Primärmagnetfeldes führt.

Die Anordnung 1 kann aus den einzelnen Konstruktionselementen 30, 36 hergestellt werden, indem zunächst jeweils ein Draht 9 um die Trägerelemente 3, 37 gewickelt wird. Sodann wird die Trägerstruktur 2 zusammengesetzt, indem die Trägerelemente 3, 37 aufeinandergeschoben werden. Hierzu werden insbesondere die Stege 39 in eine Aufnahme 38 eines benachbarten Trägerelements 37 geschoben. Bereits durch dieses Einschieben von Trägerelementen 3 in Aufnahmen 38 benachbarter Trägerelemente 37 werden benachbarte Trägerelemente 3, 37 mechanisch miteinander verbunden. Eine weitere mechanische Stabililisierung kann dadurch erfolgen, dass in Bohrungen 41, welche zur Übersichtlichkeit lediglich an zwei Stellen in Fig. 6 mit Bezugsziffern versehen sind, beispielsweise Passstifte oder, insbesondere metallische und/oder nicht magnetische, Rohre oder auch Schläuche geschoben werden, wobei die Rohre oder die Schläuche insbesondere zugleich der Zufuhr kühlenden Wassers dienen können. Eine weitere Stabilisierung kann auch dadurch erfolgen, dass eine lösbare formschlüssige Verklammerung benachbarter Trägerelemente 3, 37 beispielsweise mittels Rastelementen erfolgt oder dass durch einen weiteren Behandlungsschritt eine stoffschlüssige Verbindung zwischen den Trägerelementen 3, 37 erfolgt, welche unter Umständen auch irreversibel erfolgen kann, so dass die Trägerstruktur 2 nicht mehr zerlegbar wäre.

Bei dem in Fig. 5 - 7 gezeigten Ausführungsbeispiel ist die Anordnung 1 jedoch durch Auseinanderziehen der Trägerelemente 3, 37 zerlegbar. Dies ist insbesondere aus dem Grund möglich, dass die Leiteranordnungen 4 knotenfrei voneinander separierbar sind. Auch durch die Vorfertigung der einzelnen Konstruktionselemente 30, 36 sind die Leiteranordnungen 4 lötstellenfrei anordenbar und nach Fertigung der Anordnung 1 auch lötstellenfrei angeordnet. Hierbei fällt auf, dass die Leiteranordnungen 4 paarweise eine Verschlingungszahl von null aufweisen. Die die jeweiligen Spulen 10 bildenden Drähte 9 sind nämlich nicht umeinander gewickelt, sondern bilden jeweils eine topologisch abgeschossene Einheit, die nicht von Leitern 5 durchdrungen wird.

Zum Betrieb der in Fig. 5 abgebildeten Anordnung 1 in einem Gradienten- und/oder Shimsystem kann die Anordnung 1 in einen MR-Tomographen derart eingefügt werden, dass die axiale erste Richtung 20 entlang des vom MR-Tomographen generierten Hauptmagnetfeldes orientiert ist. Wird nun die Anordnung 1 bestromt, indem beispielsweise jede Spule 10 mit einem Gradientenverstärker verbunden wird, sind die Primärleiteranordnungen 5 unabhängig voneinander bestrombar. Durch Variierung der Ströme in den Spulen 10 ist es möglich, ein raumzeitlich variierendes Primärmagnetfeld, insbesondere entlang der axialen ersten Richtung 20, zu erzeugen, welches das Hauptmagnetfeld dergestalt modifizieren kann, dass hierdurch eine Ortskodierung ermöglicht wird und/oder dass eine Homogenisierung des Hauptmagnetfeldes eintritt, welche für einen Shimverfahren benötigt wird. Die in Fig. 5 abgebildete Anordnung 1 ist somit zur Modifizierung eines in einem MR-Tomographen generierten Hauptmagnetfeldes besonders gut geeignet.

Es wird vorgeschlagen, eine Trägerstruktur 2 einer Anordnung 1 zur Modifizierung eines in einem MR-Tomographen generierten Hauptmagnetfeldes aus mehreren Trägerelementen 3, 37 zusammenzusetzen. An jedem Trägerelement 3, 37 ist jeweils eine Leiteranordnung 4 angeordnet. Die Leiteranordnungen 4 umfassen jeweils eine Primärleiteranordnung 6 zur Generierung eines das Hauptmagnetfeld modifizierenden Primärmagnetfeldes und eine Sekundärleiteranordnung 7 zur Abschirmung des Primärmagnetfeldes. Die Erfindung betrifft auch ein Verfahren zur Herstellung einer modular konstruierbaren Anordnung 1, welche beispielsweise zur Ortskodierung verwendet werden kann.

### Bezugszeichenliste

- 1: Anordnung
- 2: Trägerstruktur
- 3: Trägerelement
- 4: Leiteranordnung
- 5: Leiter
- 6: Primärleiteranordnung
- 7: Sekundärleiteranordnung
- 8: Aufnahme
- 9: Draht
- 10: Spule
- 11: Wicklung
- 12: Oberfläche von 3
- 13: Oberfläche von 2
- 14: Teiloberfläche von 3
- 15: äußere Oberfläche von 2
- 16: innere Oberfläche von 2
- 17: obere Teiloberfläche von 3
- 18: untere Teiloberfläche von 3
- 19: mittlere Oberfläche von 2
- 20: erste Richtung
- 21: zweite Richtung
- 22: Länge von 3
- 23: Breite von 3
- 24: Teilleiteranordnung
- 25: weitere Teilleiteranordnung
- 26: Verbindungsleiter
- 27: Teiloberfläche von 3
- 28: mittiger Bereich von 3
- 29: Rille
- 30: Konstruktionselement
- 31: Rotationspunkt
- 32: Öffnung
- 33: Hohlraum
- 34: Seite von 3
- 35: weitere Seite von 3
- 36: weiteres Konstruktionselement
- 37: weiteres Trägerelement
- 38: Aufnahme von 37
- 39: Steg
- 40: untere Platte von 3
- 41: Bohrung

## Patentansprüche

1. Anordnung (1) von Gradienten- und/oder Shimspulen zur Modifizierung eines in einem Magnetresonanz-Tomographen generierten Hauptmagnetfeldes, mit einer Trägerstruktur (2), wobei die Trägerstruktur (2) mindestens vier Trägerelemente (3, 37) aufweist, wobei jedes Trägerelement (3, 37) mindestens eine Aufnahme (8, 38) zur Aufnahme eines Aufnahme-Gegenstücks eines benachbarten Trägerelements (3, 37) hat und wobei die Trägerelemente (3, 37) mit benachbarten Trägerelementen (3, 37) mechanisch verbunden sind, **dadurch gekennzeichnet, dass** die Anordnung mindestens vier Konstruktionselemente aufweist, welche jeweils eines der Trägerelemente (3, 7) und eine an diesem angeordnete Leiteranordnung (4) umfassen, wobei die Leiteranordnungen (4) jeweils mindestens einen elektrischen Leiter umfassen, dass die Leiteranordnungen (4) jeweils eine Primärleiteranordnung (6) zur Generierung eines das Hauptmagnetfeld modifizierenden Primärmagnetfeldes und eine bestrombare Sekundärleiteranordnung (7) zur Abschirmung des Primärmagnetfeldes umfassen und dass die Primärleiteranordnungen (6) unabhängig voneinander oder paarweise unabhängig bestrombar sind.

2. Anordnung (1) nach Anspruch 1, **dadurch gekennzeichnet, dass** die Leiteranordnungen (4) jeweils separat voneinander mit einer Stromquelle und/oder einer Stromversorgung verbindbar sind.

3. Anordnung (1) nach einem der Ansprüche 1 oder 2, **dadurch gekennzeichnet, dass** die Trägerelemente (3, 37) mit benachbarten Trägerelementen (3, 37) lösbar und/oder formschlüssig und/oder kraftschlüssig und/oder stoffschlüssig verbunden sind.

4. Anordnung (1) nach einem der Ansprüche 1 bis 3, **dadurch gekennzeichnet, dass** die Leiteranordnungen (4) jeweils aus genau einem Leiter (5), insbesondere einem Draht (9), bestehen und/oder dass die Leiteranordnungen (4) jeweils von mindestens einer, insbesondere genau einer, Spule (10) und/oder Wicklung (11) gebildet sind und/oder dass die Leiteranordnungen (4) jeweils verzweigungsfrei ausgebildet sind.

5. Anordnung (1) nach einem der Ansprüche 1 bis 4, **dadurch gekennzeichnet, dass** die Leiteranordnungen (4) paarweise eine Verschlingungszahl von null aufweisen und/oder dass die Leiteranordnungen (4) knotenfrei voneinander separierbar sind, insbesondere derart, dass die Anordnung (1) durch Auseinanderziehen der Trägerelemente (3, 37) zerlegbar ist, und/oder dass die Leiteranordnungen lötstellenfrei angeordnet oder anordenbar sind.

6. Anordnung (1) nach einem der Ansprüche 1 bis 5, **dadurch gekennzeichnet, dass** die Leiteranordnungen (4) jeweils auf einer äußeren Oberfläche (12) des jeweiligen Trägerelements (3, 37) angeordnet sind.

7. Anordnung (1) nach einem der Ansprüche 1 bis 6, **dadurch gekennzeichnet, dass** die Trägerstruktur (2) mindestens zwei voneinander beabstandete, insbesondere zylinderförmige oder ebene, Oberflächen (13) bildet und/oder dass die Trägerelemente (3, 37) jeweils voneinander beabstandete Teiloberflächen (14) aufweisen und dass mindestens zwei Oberflächen (13) der Trägerstruktur (2) oder die mindestens zwei Oberflächen (13) von den Teiloberflächen (14) gebildet sind, insbesondere wobei die mindestens zwei Oberflächen (13) jeweils von mindestens drei Teiloberflächen (14) gebildet sind.

8. Anordnung (1) nach einem der Ansprüche 1 bis 7, **dadurch gekennzeichnet, dass** die Trägerelemente (3, 37) in der Trägerstruktur (2) und/oder auf einer Oberfläche (13) der Trägerstruktur (2) ein zweidimensionales Gitter definieren und/oder dass die Trägerstruktur (2) eine äußere Oberfläche (15) und eine innere Oberfläche (16) aufweist und dass die Primärleiteranordnungen (6) an der inneren Oberfläche (16) und die Sekundärleiteranordnungen (7) an der äußeren Oberfläche (15) angeordnet sind.

9. Anordnung (1) nach einem der Ansprüche 1 bis 8, **dadurch gekennzeichnet, dass** die Trägerelemente (3, 37) jeweils eine obere Teiloberfläche (17), an der die jeweilige Sekundärleiteranordnung (7) angeordnet ist, und eine untere Teiloberfläche (18), an der die jeweilige Primärleiteranordnung (6) angeordnet ist, aufweisen und/oder dass mehrere oder die oberen Teiloberflächen (17) eine oder die äußere Oberfläche (15) der Trägerstruktur (2) bilden und dass die unteren Teiloberflächen (18) eine oder die innere Oberfläche (16) der Trägerstruktur (2) und/oder eine mittlere Oberfläche (19) der Trägerstruktur (2) bilden.

10. Anordnung (1) nach einem der Ansprüche 1 bis 9, **dadurch gekennzeichnet, dass** mindestens zwei Trägerelemente (3, 37) identisch ausgebildet sind und/oder dass mindestens zwei Leiteranordnungen (4) identisch ausgebildet sind oder zumindest eine gleiche räumliche Topologie aufweisen.

11. Anordnung (1) nach einem der Ansprüche 1 bis 10, **dadurch gekennzeichnet, dass** die an den Trägerelementen (3, 37) angeordneten Leiteranordnungen (4) jeweils zwei topologisch gleiche Teilleiteranordnungen (24, 25) umfassen, insbesondere wobei die Leiteranordnungen (4) und/oder die Trägerelemente (3, 37) jeweils eine 180°-Rotationssymmetrie aufweisen.

12. Anordnung (1) nach einem der Ansprüche 1 bis 11, **dadurch gekennzeichnet, dass** zumindest eine der Leiteranordnungen (4) Verbindungsleiter (26) aufweist, welche die jeweilige Primärleiteranordnung (6) mit der jeweiligen Sekundärleiteranordnung (7) verbinden.

13. Anordnung (1) nach einem der Ansprüche 1 bis 12, **dadurch gekennzeichnet, dass** die Trägerelemente (3, 37) jeweils mindestens eine Rille (29) aufweisen, in die zumindest ein Abschnitt mindestens eines Leiters (5) der jeweiligen Leiteranordnung (4) oder des mindestens einen Leiters (5) der jeweiligen Leiteranordnung (4) einlegbar oder eingelegt ist und/oder dass die Trägerelemente (3, 37) Anschlüsse oder Anschlussstellen für Anschlussleiter aufweisen.

14. Verfahren zur Herstellung einer Anordnung (1) von Gradienten- und/oder Shimspulen nach einem der Ansprüche 1 bis 13, **dadurch gekennzeichnet, dass** die Anordnung nach einem der Ansprüche 1 bis 13 ausgebildet ist und dass auf die mindestens vier Trägerelemente (3, 37) jeweils die jeweilige Leiteranordnung (4) aufgebracht wird und dass sodann die Trägerelemente (3, 37) zu der Trägerstruktur (2) zusammengesetzt werden, insbesondere indem die Trägerelemente (3, 37) mit benachbarten Trägerelementen (3, 37) mechanisch verbunden werden.

## Claims

1. Arrangement (1) of gradient and/or shim coils for modifying a main magnetic field generated in a magnetic resonance tomograph, comprising a carrier structure (2), wherein the carrier structure (2) has at least four carrier elements (3, 37), wherein each carrier element (3, 37) has at least one receptacle (8, 38) for receiving a receptacle counterpart of a neighbouring carrier element (3, 37) and wherein the carrier elements (3, 37) are mechanically connected to neighbouring carrier elements (3, 37), **characterized in that** the arrangement has at least four construction elements which each comprise one of the carrier elements (3, 7) and a conductor arrangement (4) arranged on the said one carrier element, wherein the conductor arrangements (4) each comprise at least one electrical conductor, **in that** the conductor arrangements (4) each comprise a primary conductor arrangement (6) for generating a primary magnetic field, which modifies the main magnetic field, and a secondary conductor arrangement (7), to which current can be supplied, for shielding the primary magnetic field and **in that** the primary conductor arrangements (6) can be supplied with current independently of one another or independently in pairs.

2. Arrangement (1) according to Claim 1, **characterized in that** the conductor arrangements (4) can each be connected to a current source and/or a current supply separately from one another.

3. Arrangement (1) according to either of Claims 1 and 2, **characterized in that** the carrier elements (3, 37) are connected in a releasable and/or positively locking and/or non-positively locking and/or cohesive manner to neighbouring carrier elements (3, 37).

4. Arrangement (1) according to one of Claims 1 to 3, **characterized in that** the conductor arrangements (4) each consist of precisely one conductor (5), in particular one wire (9), and/or **in that** the conductor arrangements (4) are each formed from at least one, in particular precisely one, coil (10) and/or winding (11) and/or **in that** the conductor arrangements (4) are each formed without branching.

5. Arrangement (1) according to one of Claims 1 to 4, **characterized in that** the conductor arrangements (4) in pairs have a linking number of zero and/or **in that** the conductor arrangements (4) can be separated from one another without nodes, in particular in such a way that the arrangement (1) can be dismantled by pulling the carrier elements (3, 37) apart, and/or **in that** the conductor arrangements are arranged or can be arranged without solder points.

6. Arrangement (1) according to one of Claims 1 to 5, **characterized in that** the conductor arrangements (4) are each arranged on an outer surface (12) of the respective carrier element (3, 37).

7. Arrangement (1) according to one of Claims 1 to 6, **characterized in that** the carrier structure (2) forms at least two, in particular cylindrical or planar, surfaces (13) that are spaced apart from one another, and/or **in that** the carrier elements (3, 37) each have subsurfaces (14) that are spaced apart from one another, and **in that** at least two surfaces (13) of the carrier structure (2) or the at least two surfaces (13) are formed by the subsurfaces (14), in particular wherein the at least two surfaces (13) are each formed by at least three subsurfaces (14).

8. Arrangement (1) according to one of Claims 1 to 7, **characterized in that** the carrier elements (3, 37) define a two-dimensional grid in the carrier structure (2) and/or on a surface (13) of the carrier structure (2) and/or **in that** the carrier structure (2) has an outer surface (15) and an inner surface (16) and **in that** the primary conductor arrangements (6) are arranged on the inner surface (16) and the secondary conductor arrangements (7) are arranged on the outer surface (15).

9. Arrangement (1) according to one of Claims 1 to 8, **characterized in that** the carrier elements (3, 37) each have an upper subsurface (17), on which the respective secondary conductor arrangement (7) is arranged, and a lower subsurface (18), on which the respective primary conductor arrangement (6) is arranged, and/or **in that** a plurality of or the upper subsurfaces (17) form one or the outer surface (15) of the carrier structure (2), and **in that** the lower subsurfaces (18) form one or the inner surface (16) of the carrier structure (2) and/or a middle surface (19) of the carrier structure (2).

10. Arrangement (1) according to one of Claims 1 to 9, **characterized in that** at least two carrier elements (3, 37) are identically formed and/or **in that** at least two conductor arrangements (4) are identically formed or have at least a spatial topology that is the same.

11. Arrangement (1) according to one of Claims 1 to 10, **characterized in that** the conductor arrangements (4) arranged on the carrier elements (3, 37) each comprise two subconductor arrangements (24, 25) that are topologically the same, in particular wherein the conductor arrangements (4) and/or the carrier elements (3, 37) each have a 180° rotational symmetry.

12. Arrangement (1) according to one of Claims 1 to 11, **characterized in that** at least one of the conductor arrangements (4) has connecting conductors (26), which connect the respective primary conductor arrangement (6) to the respective secondary conductor arrangement (7).

13. Arrangement (1) according to one of Claims 1 to 12, **characterized in that** the carrier elements (3, 37) each have at least one groove (29), into which at least one portion of at least one conductor (5) of the respective conductor arrangement (4) or of the at least one conductor (5) of the respective conductor arrangement (4) can be placed or has been placed and/or **in that** the carrier elements (3, 37) have terminals or terminal points for terminal conductors.

14. Method for producing an arrangement (1) of gradient and/or shim coils according to one of Claims 1 to 13, **characterized in that** the arrangement is formed according to one of Claims 1 to 13 and **in that** in each case the respective conductor arrangement (4) is applied to the at least four carrier elements (3, 37) and **in that** then the carrier elements (3, 37) are assembled to form the carrier structure (2), in particular by way of the carrier elements (3, 37) being mechanically connected to neighbouring carrier elements (3, 37).

## Revendications

1. Ensemble (1) de bobines de gradient et/ou de shim pour la modification d'un champ magnétique principal qui est généré dans un appareil d'imagerie par résonance magnétique nucléaire, comprenant une structure de support (2), dans lequel la structure de support (2) comprend au moins quatre éléments de support (3, 37), dans lequel chaque élément de support (3, 37) comporte au moins un logement (8, 38) pour le logement d'une pièce complémentaire à loger d'un élément de support (3, 37) voisin et dans lequel les éléments de support (3, 37) sont reliés de façon mécanique à des éléments de support (3, 37) voisins, **caractérisé en ce que** l'ensemble présente au moins quatre éléments de construction, lesdits éléments de construction comprenant respectivement un des éléments de support (3, 37) et un ensemble de conducteur (4) disposé sur celui-ci, dans lequel les ensembles de conducteur (4) comprennent respectivement au moins un conducteur électrique, **en ce que** les ensembles de conducteur (4) comprennent respectivement un ensemble de conducteur primaire (6) pour la génération d'un champ magnétique primaire qui modifie le champ magnétique principal et un ensemble de conducteur secondaire (7) qui peut être alimenté en courant pour le blindage du champ magnétique primaire, et **en ce que** les ensembles de conducteur primaire (6) peuvent être alimentés en courant indépendamment les uns des autres ou par paires de manière indépendante.

2. Ensemble (1) selon la revendication 1, **caractérisé en ce que** les ensembles de conducteur (4) peuvent être reliés respectivement séparément les uns des autres à une source de courant et/ou à une alimentation en courant.

3. Ensemble (1) selon l'une quelconque des revendications 1 ou 2, **caractérisé en ce que** les éléments de support (3, 37) sont reliés à des éléments de support (3, 37) voisins de manière détachable et/ou par coopération de formes et/ou par force et/ou par liaison de matières.

4. Ensemble (1) selon l'une quelconque des revendications 1 à 3, **caractérisé en ce que** les ensembles de conducteur (4) sont constitués respectivement d'exactement un conducteur (5), en particulier d'un fil (9), et/ou **en ce que** les ensembles de conducteur (4) sont constitués respectivement d'au moins un(e), en particulier d'exactement un(e), bobine (10) et/ou enroulement (11) et/ou **en ce que** les ensembles de conducteur (4) sont réalisés respectivement sans ramification.

5. Ensemble (1) selon l'une quelconque des revendications 1 à 4, **caractérisé en ce que** les ensembles de conducteur (4) présentent par paires un enlacement de zéro et/ou que les ensembles de conducteur (4) peuvent être séparés les uns des autres sans nœud, en particulier de telle sorte que l'ensemble (1) puisse être décomposé par séparation des éléments de support (3, 37) par traction, et/ou **en ce que** les ensembles de conducteur sont disposés ou peuvent être disposés sans soudure.

6. Ensemble (1) selon l'une quelconque des revendications 1 à 5, **caractérisé en ce que** les ensembles de conducteur (4) sont disposés respectivement sur une surface extérieure (12) de l'élément de support (3, 37) respectif.

7. Ensemble (1) selon l'une quelconque des revendications 1 à 6, **caractérisé en ce que** la structure de support (2) forme au moins deux surfaces (13) qui sont espacées l'une de l'autre, en particulier cylindriques ou planes, et/ou **en ce que** les éléments de support (3, 37) présentent respectivement des surfaces partielles (14) qui sont respectivement espacées les unes des autres, et **en ce qu'**au moins deux surfaces (13) de la structure de support (2) ou lesdites au moins deux surfaces (13) sont formées par les surfaces partielles (14), en particulier dans lequel lesdites au moins deux surfaces (13) sont formées respectivement par au moins trois surfaces partielles (14).

8. Ensemble (1) selon l'une quelconque des revendications 1 à 7, **caractérisé en ce que** les éléments de support (3, 37) définissent une grille bidimensionnelle dans la structure de support (2) et/ou sur une surface (13) de la structure de support (2), et/ou **en ce que** la structure de support (2) présente une surface extérieure (15) et une surface intérieure (16) et **en ce que** les ensembles de conducteur primaire (6) sont disposés sur la surface intérieure (16) et les ensembles de conducteur secondaire (7) sont disposés sur la surface extérieure (15).

9. Ensemble (1) selon l'une quelconque des revendications 1 à 8, **caractérisé en ce que** les éléments de support (3, 37) présentent respectivement une surface partielle supérieure (17), surface sur laquelle l'ensemble de conducteur secondaire (7) respectif est disposé, et une surface partielle inférieure (18), sur laquelle l'ensemble de conducteur primaire (6) respectif est disposé, et/ou **en ce que** plusieurs ou les surfaces partielles supérieures (17) forment une ou la surface extérieure (15) de la structure de support (2) et **en ce que** les surfaces partielles inférieures (18) forment une ou la surface intérieure (16) de la structure de support (2) et/ou une surface centrale (19) de la structure de support (2).

10. Ensemble (1) selon l'une quelconque des revendications 1 à 9, **caractérisé en ce qu'**au moins deux éléments de support (3, 37) sont réalisés de manière identique et/ou qu'au moins deux ensembles de conducteur (4) sont réalisés de manière identique ou présentent au moins une topologie spatiale similaire.

11. Ensemble (1) selon l'une quelconque des revendications 1 à 10, **caractérisé en ce que** les ensembles de conducteur (4) disposés sur les éléments de support (3, 37) comprennent respectivement deux ensembles de conducteur partiel (24, 25) qui présentent une topologie similaire, en particulier dans lequel les ensembles de conducteur (4) et/ou les éléments de support (3, 37) présentent respectivement une symétrie de rotation à 180°.

12. Ensemble (1) selon l'une quelconque des revendications 1 à 11, **caractérisé en ce qu'**au moins un des ensembles de conducteur (4) comprend des conducteurs de liaison (26), lesdits conducteurs de liaison reliant l'ensemble de conducteur primaire (6) respectif à l'ensemble de conducteur secondaire (7) respectif.

13. Ensemble (1) selon l'une quelconque des revendications 1 à 12, **caractérisé en ce que** les éléments de support (3, 37) comportent respectivement au moins une rainure (29), dans laquelle au moins une partie d'au moins un conducteur (5) de l'ensemble de conducteur (4) respectif ou dudit au moins un conducteur (5) de l'ensemble de conducteur (4) respectif peut être insérée ou est insérée, et/ou **en ce que** les éléments de support (3, 37) présentent des raccordements ou des points de raccordement prévus pour des conducteurs de raccordement.

14. Procédé pour la fabrication d'un ensemble (1) de bobines de gradient et/ou de shim selon l'une quelconque des revendications 1 à 13, **caractérisé en ce que** l'ensemble est réalisé selon l'une quelconque des revendications 1 à 13, et **en ce que** l'ensemble de conducteur (4) respectif est respectivement appliqué sur lesdits au moins quatre éléments de support (3, 37) et qu'ensuite les éléments de support (3, 37) sont assemblés en la structure de support (2), en particulier du fait que les éléments de support (3, 37) sont reliés de façon mécanique à des éléments de support (3, 37) voisins.
